# EUROPEAN PATENT APPLICATION

(11) **EP 4 703 132 A1**
(43) Date of publication of application: **04.03.2026**
(21) Application number: 23935443.4
(22) Date of filing: 04.12.2023
(51) Int. Cl.: B32B 7/023, B32B 9/00, G02B 1/14, G02B 1/115

(54) **REFLECTANCE ADJUSTMENT FILM, MULTILAYER BODY, AND METHOD FOR PRODUCING REFLECTANCE ADJUSTMENT FILM**

(30) Priority: 28.04.2023 JP 2023075063
(71) Applicant: Towa Corporation, Kyoto-shi, Kyoto 601-8105 (JP)
(72) Inventor: OGAWA Yuhei, Kyoto-shi, Kyoto 601-8105 (JP); KISHIMOTO Tomoko, Kyoto-shi, Kyoto 601-8105 (JP)
(74) Representative: Vossius & Partner Patentanwälte Rechtsanwälte mbB
(86) International application number: PCT/JP2023/043305
(87) International publication number: WO 2024/224672

(57) **Abstract**

Provided is a reflectance adjustment film having high hardness. A reflectance adjustment film (10) for adjusting reflectance of light includes a plurality of films laminated together. The plurality of films include a low refractive index film (11) and a high refractive index film (12) having a refractive index higher than that of the low refractive index film (11), the low refractive index film (11) is formed of a mixture of silicon dioxide (SiO₂) and yttrium oxide (Y₂O₃), where some of the yttrium (Y) atoms in the yttrium oxide (Y₂O₃) are substituted with Group 4A element atoms, and at least one of the films adjacent to the high refractive index film (12) has a refractive index lower than that of the high refractive index film (12).

## Description

### TECHNICAL FIELD

The present disclosure relates to a reflectance adjustment film, a laminate, and a method for producing the reflectance adjustment film.

### BACKGROUND ART

On a glass substrate or the like, a reflectance adjustment film is sometimes laminated for adjusting reflectance of light. For example, Patent Literature 1 describes an antireflection film for preventing reflection of light, as a reflectance adjustment film. The antireflection film of Patent Literature 1 can be formed, for example, by alternately laminating a low refractive index film and a high refractive index film on a glass substrate.

### Citation List

### Patent Literature

Patent Literature 1: WO 2019/151321

### SUMMARY OF INVENTION

### Technical Problem

The reflectance adjustment film with configuration as described in Patent Document 1 has low hardness (is soft), and thus may be damaged during the use or the like. Accordingly, for the purpose of increasing the hardness of the reflectance adjustment film to improve the scratch resistance and the like, a hard coat layer may be provided on the substrate as a layer other than the reflectance adjustment film.

However, in the case of providing the hard coat layer as a film separate from the reflectance adjustment film, the production processes accordingly increase. In addition, when forming a reflectance adjustment film on the hard coat layer, foreign matters may be mixed into the reflectance adjustment film.

Hence, it is an object of the present disclosure to provide a reflectance adjustment film having high hardness, a laminate in which the reflectance adjustment film is formed, and a method for producing the reflectance adjustment film.

### Solution to Problem

To achieve the above object, the present disclosure provides a reflectance adjustment film for adjusting reflectance of light, including:
a plurality of films laminated together, wherein
the plurality of films includes:
   a low refractive index film, and
   a high refractive index film having a refractive index higher than that of the low refractive index film,
   the low refractive index film is formed of a mixture including silicon dioxide (SiO₂) and yttrium oxide (Y₂O₃), where some of the yttrium (Y) atoms in the yttrium oxide (Y₂O₃) are substituted with Group 4A element atoms, and
   at least one of the films adjacent to the high refractive index film has a refractive index lower than that of the high refractive index film.

The present disclosure also provides a laminate including the reflectance adjustment film of the present disclosure, the reflectance adjustment film being formed on at least one surface of a substrate.

The present disclosure also provides a method for producing the reflectance adjustment film of the present disclosure, including:
forming the low refractive index film, and
forming the high refractive index film, wherein
the low refractive index film is formed by sputtering in the forming the low refractive index film, and
the high refractive index film is formed by sputtering in the forming the high refractive index film.

### Advantageous Effects of Invention

The present disclosure can provide a reflectance adjustment film having high hardness, a laminate in which the reflectance adjustment film is formed, and a method for producing the reflectance adjustment film.

### BRIEF DESCRIPTION OF DRAWINGS

[FIG. 1] FIG. 1 is a cross-sectional view showing an example of the reflectance adjustment film of the present disclosure and the laminate of the present disclosure.
[FIG. 2] FIG. 2 is a cross-sectional view showing an example of the laminate of the present disclosure including a hard coat layer and a reflectance adjustment film.

### DESCRIPTION OF EMBODIMENTS

As used herein, "on" or "on a surface" may refer to a state of direct contact on or on a surface, and may also refer to a state of contact via another layer or the like.

As used herein, "suppression" of some phenomena is not limited to reduction of the occurrence of those phenomena, and also includes elimination of the occurrence of those phenomena, unless otherwise specified.

As used herein, a "reflectance adjustment film" refers to a film-like structure capable of adjusting reflectance of incident light by changing the film thickness, the refractive index, or the like, unless otherwise specified.

As used herein, "film thickness" may refer to "physical film thickness", and may also refer to "optical film thickness", unless otherwise specified.

Hereinafter, specific embodiments of the present disclosure will be described with reference to the drawings and the like as necessary. For convenience of description, the drawings are schematically illustrated with appropriate omission, exaggeration, or the like. In addition, when mechanisms and principles are referred to in the following embodiments and examples, the described mechanisms and principles are merely estimation, and the present invention is not limited to the described mechanisms and principles.

### [1. Reflectance Adjustment Film and Laminate]

First, the reflectance adjustment film of the present disclosure and the laminate of the present disclosure will be described with reference to illustrative examples.

### [1-1. Configuration of Reflectance Adjustment Film and Laminate, etc.]

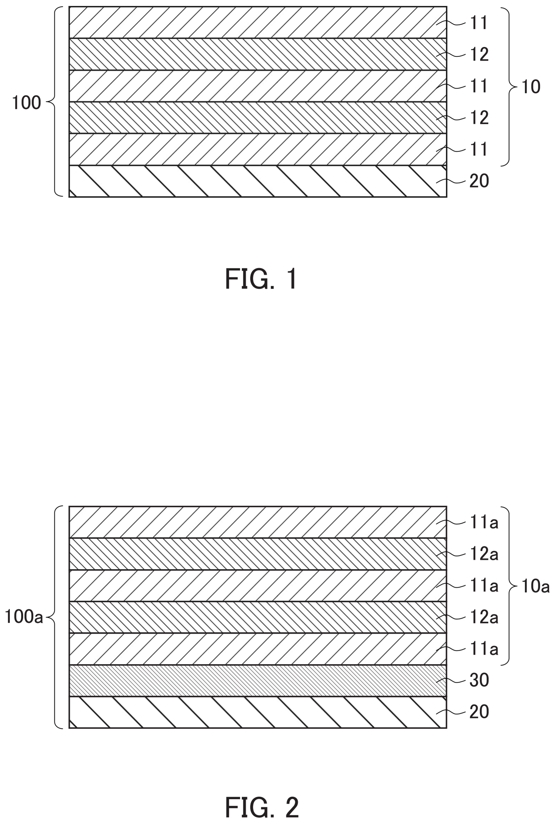

The cross-sectional view of FIG. 1 schematically shows an example of configuration of the reflectance adjustment film of the present disclosure and the laminate of the present disclosure including the reflectance adjustment film. As shown in FIG. 1, in a laminate 100 of the present disclosure, a reflectance adjustment film 10 of the present disclosure is formed on one surface of a substrate 20. The reflectance adjustment film 10 is a film formed by laminating a plurality of films (a low refractive index film 11 and a high refractive index film 12 to be described later) on which light is incident. The reflectance adjustment film 10 is formed by alternately laminating the low refractive index film 11 and the high refractive index film 12. As shown in FIG. 1, the film adjacent to the substrate 20 and the film farthest from the substrate 20 are the low refractive index films 11.

Lamination order of the low refractive index film 11 and the high refractive index film 12 is not particularly limited. When the reflectance adjustment film 10 is used as an antireflection film, the film farthest from the substrate 20 is the low refractive index film 11.

In FIG. 1, the number of layers of the low refractive index films 11 is 3, and the number of layers of the high refractive index film 12 is 2. However, in the reflectance adjustment film of the present disclosure, the number of the low refractive index film and the number of the high refractive index film are not limited, as long as at least one low refractive index film and at least one high refractive index film are provided. In the reflectance adjustment film of the present disclosure, the lower limit of the total number of the layers of the low refractive index film and the high refractive index film is preferably 3 or more, and more preferably 5 or more. The upper limit thereof is not particularly limited, and may be, for example, 30 or less, 20 or less, 15 or less, or 10 or less. The smaller the total number of the low refractive index film and the high refractive index film is (that is, the smaller the total number of layers of the low refractive index films and the high refractive index films is), the shorter the time required for the production of the reflectance adjustment film of the present disclosure becomes, or the lower the cost required for the production becomes, which are preferable. On the other hand, the larger the total number of the low refractive index film and the high refractive index film is (that is, the larger the total number of layers of the low refractive index film and the high refractive index film is), the easier the achievement of the desired reflectance and the like in the reflectance adjustment film of the present disclosure becomes, which is preferable.

The substrate 20 is not particularly limited and may be, for example, a plate-like substrate. The material for the substrate 20 may be glass, resin, or the like. Examples of the glass include a glass plate, and a glass lens. Examples of the resin include a resin plate, and a resin lens. The resin is not particularly limited, and examples thereof include polyolefin, polyester, polycarbonate (PC), and acrylic resin. Examples of the polyolefin include PP (polypropylene), PE (polyethylene), and COP (cycloolefin polymer). Examples of the polyester include PET (polyethylene terephthalate). Examples of the acrylic resin include PMMA (polymethyl methacrylate). In FIG. 1, the substrate 20 is a single layer, but is not limited thereto, and may be a laminate of a plurality of layers, where each of the layers may be identical or different from each other. The laminate 100 may be, for example, a lens, window glass, or the like including the reflectance adjustment film 10.

The reflectance adjustment film 10 of FIG. 1 includes only the low refractive index film 11 and the high refractive index film 12. However, the reflectance adjustment film of the present disclosure is not limited thereto, and may include a layer other than the low refractive index film and the high refractive index film. In the reflectance adjustment film 10 of FIG. 1, the number of layers of the low refractive index film 11 is 3, and the number of layers of the high refractive index film 12 is two, and the low refractive index film 11 and the high refractive index film 12 are laminated in direct contact with each other. However, the configuration of the present disclosure is not limited to this configuration, and for example, the films may be laminated via a layer other than the low refractive index film and the high refractive index film. Further, in FIG. 1, the reflectance adjustment film 10 is laminated on the substrate 20 in direct contact therewith. However, the present disclosure is not limited thereto, and for example, the reflectance adjustment film 10 may be laminated on the substrate 20 via a layer other than the low refractive index film 11 and the high refractive index film 12. However, it is preferable that the reflectance adjustment film of the present disclosure and the laminate of the present disclosure do not include a layer other than the low refractive index film and the high refractive index film, from the viewpoint of suppressing foreign matters derived from the other layer or the like being mixed into the reflectance adjustment film.

FIG. 2 shows an example of the laminate of the present disclosure including a hard coat layer and a reflectance adjustment film. As shown in FIG. 2, in this laminate 100a, a hard coat layer 30 is formed on one surface of a substrate 20, and a reflectance adjustment film 10a is formed on the surface of the hard coat layer 30 opposite to the surface facing the substrate 20. The reflectance adjustment film 10a is formed by alternately laminating a low refractive index film 11a and a high refractive index film 12a. In FIG. 2, the film adjacent to the hard coat layer 30 (closest to the substrate 20) and the film farthest from the substrate 20 are the low refractive index films 11a.

When the hard coat layer is used as a layer separate from the reflectance adjustment film as shown in FIG. 2, for example, the hardness of the reflectance adjustment film can be increased, and the scratch resistance and the like can be improved. However, in the case of providing the hard coat layer, the production processes accordingly increase, as described above. In addition, in the case of forming the reflectance adjustment film on the hard coat layer, foreign matters may be mixed into the reflectance adjustment film. In this respect, the reflectance adjustment film 10 of FIG. 1 has high hardness even without the hard coat layer, and thus solves such problems.

In the reflectance adjustment film of the present disclosure, as described above, the low refractive index film is formed of a mixture including silicon dioxide (SiO₂) and yttrium oxide (Y₂O₃), where some of the yttrium (Y) atoms in the yttrium oxide (Y₂O₃) are substituted with Group 4A element atoms. In the yttrium oxide (Y₂O₃), some of the oxygen (O) atoms may also be substituted with nitrogen (N) atoms. By substituting some of the oxygen (O) atoms in the yttrium oxide (Y₂O₃) with nitrogen (N) atoms, it is expected to impart low adhesion with a substance having basicity, and antifouling property with respect to a certain kind of substance. It is considered that the adhesion and the antifouling property are imparted, for example, by deactivation of a hydroxyl group, which is an active group on the surface of the reflectance adjustment film, due to the substitution of some of the oxygen (O) atoms with nitrogen (N) atoms.

Note that, yttrium oxide (Y₂O₃) has higher hardness than that of silicon dioxide (SiO₂). Therefore, the film formed of a mixture including yttrium oxide (Y₂O₃) and silicon dioxide (SiO₂) is considered to have higher hardness than that of a low refractive index film composed only of silicon dioxide (SiO₂). Further, when some of the yttrium (Y) atoms in the yttrium oxide (Y₂O₃) are substituted with Group 4A element atoms, for example, bonding of crystals forming the low refractive index film is strengthened. For this, when some of the yttrium (Y) atoms in the low refractive index film are substituted with Group 4A element atoms, the hardness is considered to be higher than that in a case where none of the yttrium atoms are substituted.

The hardness of the reflectance adjustment film of the present disclosure is not particularly limited. However, when the substrate is glass, the hardness of the reflectance adjustment film is preferably 6.0 GPa or more, and more preferably 6.1 GPa or more. The upper limit thereof is, for example, 11 GPa or less.

In the present disclosure, the hardness is a numerical value measured by the method described in Examples below. However, in the present disclosure, the hardness may be measured by a method other than the measurement method described below.

The reflectance adjustment film of the present disclosure may be an antireflection film, but not limited thereto. For example, the reflectance adjustment film of the present disclosure may have light transmittance of approximately 0%. The reflectance adjustment film may be, for example, a mirror having light reflectance of approximately 100%. In the reflectance adjustment film of the present disclosure, reflectance of light, transmittance of light, and the like can be adjusted by, for example, appropriately setting the number, the film thickness, the refractive index, the lamination order, or the like of each of the low refractive index film and the high refractive index film. In addition, in the reflectance adjustment film of the present disclosure, reflectance of light, transmittance of the light, and the like can be adjusted, for example, so as to vary with the wavelength of light.

In the reflectance adjustment film of the present disclosure, the reflectance is adjusted by, for example, the following method. As described above, the reflectance adjustment film of the present disclosure is formed by laminating a plurality of films. The refractive indices of the plurality of films adjacent to each other are different from each other. Here, when light is incident from one film to another, and the refractive indices of the two adjacent films are different from each other, part of the incident light is reflected at the boundary between the two adjacent films. The larger the difference between the refractive indices of the two adjacent layers, the larger the intensity of the reflected light becomes. Further, the film thickness of the plurality of laminated films affects phase of the reflected light generated at the boundary between the two adjacent films. In the reflectance adjustment film of the present disclosure, light is reflected at each boundary of the plurality of laminated films. Therefore, the reflectance in the reflectance adjustment film of the present disclosure can be adjusted by adjusting the refractive indices and the film thickness of the plurality of laminated films.

In a case where the reflectance adjustment film of the present disclosure is an antireflection film, the upper limit of the light reflectance is not particularly limited, and the average reflectance in visible light (380 nm to 780 nm) is preferably 2.5% or less, more preferably 2.0% or less, 1.5% or less, or 1.0% or less. The lower limit of the reflectance is not particularly limited and is, for example, 0 or a value greater than 0.

In the present disclosure, the reflectance of light may be measured using a device capable of measuring the reflectance of light. Examples of the device capable of measuring the reflectance of light include a reflective spectroscopic film thickness meter (trade name: FE-3000) manufactured by Otsuka Electronics Co., Ltd. The reflectance of light can be a numerical value determined from the wavelength of the incident light, the film thickness of the low refractive index film and the high refractive index film, the optical constants of these films, and the optical constant of the substrate. However, in the present disclosure, the reflectance of light may be measured by a method other than the above-described measurement method. Further, in the present disclosure, the reflectance of light may be an actual measurement value obtained by using a device, or may be a simulation value calculated by optical simulation software or the like.

### [1-2. Low Refractive Index Film]

Hereinafter, the low refractive index film in the reflectance adjustment film of the present disclosure will be described with reference to illustrative examples.

The refractive index of the low refractive index film is not particularly limited, and for example, the refractive index with respect to light having a wavelength of 500 nm is in a range of 1.47 to 1.58.

In the present disclosure, the refractive index may be, for example, a numerical value measured using a device capable of measuring refractive indices. Examples of the device capable of measuring refractive indices include a reflective spectroscopic film thickness meter (trade name: FE-3000) manufactured by Otsuka Electronics Co., Ltd. However, in the present disclosure, the refractive index may be measured by a method other than the following measurement method.

As described above, the low refractive index film in the reflectance adjustment film of the present disclosure is formed of a mixture including silicon dioxide (SiO₂) and yttrium oxide (Y₂O₃), where some of the yttrium (Y) atoms in yttrium oxide (Y₂O₃) are substituted with Group 4A element atoms. In the yttrium oxide (Y₂O₃), some of the oxygen (O) atoms may also be substituted with nitrogen (N) atoms. The content of the yttrium oxide in the low refractive index film is not particularly limited, and for example, the lower limit thereof is preferably 1.0 mol% or more, and more preferably 1.1 mol% or more, and from the viewpoint of improving the antireflection property, the upper limit thereof is preferably less than 10 mol%, and more preferably less than 6 mol%.

In the present disclosure, the content of atoms in the film can be, for example, a numerical value measured by an X-ray photoelectron spectrometer. Examples of the X-ray photoelectron spectrometer include an X-ray photoelectron spectrometer (trade name: PHI5000 VersaProbe2) manufactured by ULVAC-PHI, Inc. Using the X-ray photoelectron spectrometer, a sample is irradiated with X-rays, and the energy of the photoelectrons emitted from the surface of the sample is measured, whereby information on the composition and the chemical bonding state of the surface can be obtained. Thus, the content of atoms in the film can be measured. In the present disclosure, the content of atoms in the film may be measured by a method other than the following measurement method.

The low refractive index film in the reflectance adjustment film of the present disclosure may or may not necessarily include a component other than silicon dioxide (SiO₂) and yttrium oxide (Y₂O₃). Examples of the other component include magnesium fluoride (MgF₂).

In the reflectance adjustment film of the present disclosure, some of the yttrium (Y) atoms in the yttrium oxide (Y₂O₃) included in the low refractive index film are substituted with Group 4A element atoms. The Group 4A element atoms are not particularly limited and may be, for example, at least one type selected from the group consisting of titanium (Ti), zirconium (Zr) and hafnium (Hf), and preferably at least one of zirconium (Zr) or hafnium (Hf), and particularly preferably zirconium (Zr). These atoms or these forming materials may be used alone or in combination of two or more of these atoms and these forming materials.

In the reflectance adjustment film of the present disclosure, some of the yttrium (Y) atoms in the yttrium oxide (Y₂O₃) included in the low refractive index film are substituted with Group 4A element atoms, and thus, for example, high hardness (scratch resistance or the like) can be obtained. The reason for this is considered to be that, for example, when some of the yttrium (Y) atoms are substituted with Group 4A element atoms (e.g., zirconium (Zr)), the hardness becomes higher than that when using the yttrium oxide (Y₂O₃).

Further, the low refractive index film in the reflectance adjustment film of the present disclosure may be, for example, crystalline. The crystallinity of the low refractive index film can be determined by a general crystallinity evaluation method such as X-ray diffraction, electron diffraction, and Raman spectroscopy. Whether the low refractive index film includes yttrium oxide that contains nitrogen and Group 4A elements can be determined by, for example, Secondary Ion Mass Spectrometry (SIMS).

In the low refractive index film, the ratio of the substitution of the yttrium (Y) atoms with the Group 4A element atoms (content of the Group 4A element atoms) in the yttrium oxide (Y₂O₃) is not particularly limited as long as it is larger than 0, and the upper limit thereof may be, for example, 20 mol% or less, 15 mol% or less, 10 mol% or less, or 5 mol% or less.

When some of the oxygen (O) atoms in the yttrium oxide (Y₂O₃) in the low refractive index film are substituted with nitrogen (N) atoms, the ratio of the substitution of the oxygen (O) atoms with the nitrogen (N) atoms (content ratio of the nitrogen atoms) in the yttrium oxide (Y₂O₃) is not particularly limited as long as it is larger than 0, and may be 1 at% or more, and the upper limit thereof may be, for example, 10 at% or less, 5 at% or less, 3 at% or less, or 2 at% or less.

The low refractive index film may be free of metal elements that are allergenic or toxic, such as Hg, Ni, Cr, Co, Cu, Sn, Au, Pt, Pd, Sb, Ag, Fe, and Zn.

The physical film thickness of the low refractive index film is not particularly limited and can be appropriately selected depending on the desired optical properties.

In the present disclosure, the physical film thickness can be a numerical value measured by a spectroscopic film thickness meter. Using the spectroscopic film thickness meter, a sample is irradiated with light, a phase shift is generated based on the difference between optical paths of the reflected light and the irradiated light, an optical interference phenomenon is caused by the phase shift, and the optical interference phenomenon is measured to obtain the reflection spectrum and the refractive index, wherefrom the film thickness can be determined. Examples of the spectroscopic film thickness meter include a reflective spectroscopic film thickness meter (trade name: FE-3000) manufactured by Otsuka Electronics Co., Ltd. However, in the present disclosure, the physical film thickness may be measured by a method other than the above-described measurement method.

### [1-3. High Refractive Index Film]

Hereinafter, the high refractive index film in the reflectance adjustment film of the present disclosure will be described with illustrative examples.

The refractive index of the high refractive index film is not particularly limited as long as it is higher than that of the low refractive index film, and for example, the lower limit of the refractive index with respect to light having a wavelength of 500 nm is preferably 1.9 or more, and the upper limit thereof is preferably 2.75 or less, 2.5 or less, or 2.3 or less.

In the reflectance adjustment film of the present disclosure, the material for forming the high refractive index film is not particularly limited and may be, for example, at least one selected from the group consisting of tantalum pentoxide (Ta₂O₅), niobium pentoxide (Nb₂O₅), titanium oxide (TiO₂), zirconium oxide (ZrO₂), and cerium oxide (CeO₂), or may be other materials. From the viewpoint of achieving both hardness and refractive index, the high refractive index film is preferably formed of tantalum pentoxide. When the high refractive index film is formed of tantalum pentoxide, the high refractive index film may or may not necessarily include other materials. These atoms or these forming materials may be used alone, or in combination of two or more of these atoms and these forming materials.

The physical film thickness of the high refractive index film is not particularly limited, and can be appropriately selected depending on the desired optical properties.

### [1-4. Other Films]

The reflectance adjustment film of the present disclosure may include, for example, other films. Examples of the other films include a medium refractive index film. The medium refractive index film is not particularly limited as long as it has a refractive index higher than that of the low refractive index film and lower than that of the high refractive index film. The material for forming the medium refractive index film is not particularly limited and may be, for example, aluminum oxide (Al₂O₃), or may be other materials.

### [2. Method for Producing Reflectance Adjustment Film and Method for Producing Laminate]

A method for producing the reflectance adjustment film of the present disclosure and the laminate of the present disclosure is not particularly limited and may be, for example, sequentially forming the low refractive index film and the high refractive index film on the substrate.

A method for forming the low refractive index film and the high refractive index film in the reflectance adjustment film of the present disclosure is not particularly limited and preferably, for example, vacuum deposition, sputtering, ion plating, or ion beam deposition, each classified as physical vapor deposition; or atomic layer deposition or a plasma CVD method, each classified as chemical vapor deposition. In the vapor deposition, the film formation rate is high, but thus formed film tends to have low hardness (be soft). In the sputtering, the film formation rate is low, but thus formed film tends to have high hardness (be hard). In the reflectance adjustment film of the present disclosure, the low refractive index film and the high refractive index film are preferably formed by the sputtering, from a viewpoint of their hardness. As described above, the method of producing the reflectance adjustment film of the present disclosure and the method of manufacturing the laminate of the present disclosure include forming the low refractive index film where the low refractive index film is formed by sputtering, and forming the high refractive index film where the high refractive index film is formed by sputtering.

In order to substitute some of the oxygen (O) atoms with nitrogen (N) atoms in the yttrium oxide (Y₂O₃) included in the low refractive index film, for example, a film may be formed by sputtering (reactive sputtering) under an atmosphere in which nitrogen (N₂) is added to argon (Ar).

In the forming the low refractive index film and the forming the high refractive index film in the method for producing the reflectance adjustment film of the present disclosure and the method for producing the laminate of the present disclosure, a method for performing the sputtering is not particularly limited, and may be the same as or based on a general method of sputtering, for example.

In the forming the low refractive index film and the forming the high refractive index film, it is preferable that the film formation rate by the sputtering be not too low from the viewpoint of production efficiency, and it is preferable that the film formation rate by the sputtering be not too fast from the viewpoint of film hardness.

### Examples

Hereinafter, the examples of the present disclosure will be described. However, the present disclosure is not limited to the following examples.

### <Use Materials>

As targets for forming a low refractive index film, silicon dioxide (SiO₂), yttrium oxide (Y₂O₃), and zirconium oxide (ZrO₂) were used. As a target for forming a high refractive index film, tantalum pentoxide (Ta₂O₅) was used. As a substrate, glass was used.

### <Production of Laminate Including Reflectance Adjustment Film>

Laminates in which the reflectance adjustment films of Examples 1 to 3 and Comparative Example 1 were respectively formed were produced by sputtering. The sputtering of the low refractive index film and the high refractive index film described below was performed under an atmosphere in which nitrogen (N₂) was added to argon (Ar). First, the targets for forming the low refractive index film were sputtered on one surface of the substrate so that the composition of the yttrium oxide (Y₂O₃) be the composition shown in Table 1 below, thereby forming a low refractive index film (first layer: physical film thickness 250 nm).Then, the target for forming the high refractive index film was sputtered on the surface of the low refractive index film serving as the first layer to form a high refractive index film (second layer: physical film thickness 15 nm). Then, the targets for forming the low refractive index film were sputtered on the surface of the high refractive index film serving as the second layer so that the composition of the yttrium oxide (Y₂O₃) be the composition shown in Table 1 below, thereby forming a low refractive index film (third layer: physical film thickness 30 nm). Then, the target for forming the high refractive index film was sputtered on the surface of the low refractive index film serving as the third layer to form a high refractive index film (fourth layer: physical film thickness 115 nm). Finally, the targets for forming the low refractive index film were sputtered on the surface of the high refractive index film serving as the fourth layer so that the composition of the yttrium oxide (Y₂O₃) be the composition shown in Table 1 below, thereby forming a low refractive index film (fifth layer: physical film thickness 86 nm). Thus obtained laminate in which the reflectance adjustment film was formed on the glass substrate was evaluated. In the low refractive index film formed by the above-described method, some of the yttrium (Y) atoms in the yttrium oxide (Y₂O₃) are substituted with zirconium (Zr) atoms, and some of the oxygen (O) atoms in the yttrium oxide (Y₂O₃) are substituted with nitrogen (N) atoms.

### <Evaluation Method >

With respect to the low refractive index films formed as described above, (1) Refractive index was measured in accordance with the following procedure. In addition, (2) Hardness and (3) Average reflectance of the laminates in which the reflectance adjustment films of Examples 1 to 3 and Comparative Example 1 were respectively formed were measured in accordance with the following procedure.

### (1) Refractive index

The refractive index of the low refractive index films at a light wavelength of 500 nm was measured using a reflective spectroscopic film thickness meter (manufactured by Otsuka Electronics Co., Ltd., trade name: FE-3000). The results are shown in Table 1 below.

### (2) Hardness

The hardness of the reflectance adjustment films in the produced laminates was measured using a nano indenter (manufactured by ELIONIX INC., trade name: ENT-1100a). Using Berkovich indenter, the nanoindentation hardness (hardness) was measured when the reflectance adjustment film was pressed with a maximum load of 1. 5 mN. Specifically, first, the indenter was pressed into the sample by applying a load at a constant rate until reaching the maximum load. Next, the load was removed at a constant rate until the load became 0, and the indenter was separated from the sample. The displacement of the indenter during the loading and the unloading was recorded to determine the maximum load. Next, the projected contact area (bottom area of the cone) of the contacting portion when the indenter was pushed in was obtained. The obtained maximum load was divided by the projected contact area to obtain the nanoindentation hardness. The results are shown in Table 1 below.

### (3) Average reflectance

The simulation value of the average reflectance in the visible light region (380 nm to 780 nm) was calculated using optical simulation software (distributed by EastWind Tsusho Inc., trade name: ThinFilmView). The results are shown in Table 1 below.

**[Table 1]**

| | Y₂O₃ composition (mol%) | Low refractive index film Refractive index | Hardness (GPa) | Average reflectance (%) |
|---|---|---|---|---|
| Example 1 | 1.13 | 1.47 | 6.0 | 0.64 |
| Example 2 | 1.17 | 1.54 | 6.1 | 1.29 |
| Example 3 | 5.23 | 1.57 | 6.9 | 1.82 |
| Comparative Example 1 | 0.00 | 1.46 | 5.8 | 0.69 |

As shown in Table 1, the hardness in Examples 1 to 3 was higher than that in Comparative Example 1. Further, the hardness was improved by increasing the content of the yttrium oxide (Y₂O₃) in the low refractive index film. Further, the simulation showed that the average reflectance is changed by altering the content of the yttrium oxide (Y₂O₃) in the low refractive index film.

The laminates of Examples 1 to 3 all had a total light transmission of 95% as measured with an UV-Vis-NIR spectrophotometer (manufactured by Shimadzu Corporation, trade name: SolidSpec-3700), and demonstrated excellence in transparency (not shown in Table 1). Furthermore, all of the laminates of Examples 1 to 3 had a pencil hardness (in conformity with the former JIS K5400) of 9H or more, and demonstrated high hardness (not shown in Table 1). In addition, in the low refractive index films formed by the method according to the present example, some of the oxygen (O) atoms in the yttrium oxide (Y₂O₃) were substituted with nitrogen (N) atoms. However, even in a low refractive index film in which none of the oxygen (O) atoms in the yttrium oxide (Y₂O₃) were substituted with nitrogen (N) atoms, the hardness was improved by increasing the content of the yttrium oxide (Y₂O₃) in the low refractive index film (not shown in Table 1).

The present invention is not limited to the above-described embodiments. Various combination, changes, and selections may be made freely and appropriately in the configuration and specifics of the present invention without departing from the scope of the present invention.

The whole or part of the example embodiments disclosed above can be described as, but not limited to, the following supplementary notes.

### (Supplementary Note 1)

A reflectance adjustment film for adjusting reflectance of light, including:
a plurality of films laminated together, wherein
the plurality of films includes:
   a low refractive index film, and
   a high refractive index film having a refractive index higher than that of the low refractive index film,
   the low refractive index film is formed of a mixture including silicon dioxide (SiO₂) and yttrium oxide (Y₂O₃), where some of the yttrium (Y) atoms in the yttrium oxide (Y₂O₃) are substituted with Group 4A element atoms, and
   at least one of the films adjacent to the high refractive index film has a refractive index lower than that of the high refractive index film.

### (Supplementary Note 2)

The reflectance adjustment film according to Supplementary Note 1, wherein
some of the oxygen atoms in the yttrium oxide (Y₂O₃) are substituted with nitrogen (N) atoms.

### (Supplementary Note 3)

The reflectance adjustment film according to Supplementary Note 1 or 2, wherein
content of the yttrium oxide (Y₂O₃) in the low refractive index film is 1.0 mol% or more.

### (Supplementary Note 4)

The reflectance adjustment film according to any one of Supplementary Notes 1 to 3, wherein
the Group 4A element atoms in the low refractive index film are zirconium (Zr) atoms.

### (Supplementary Note 5)

A reflectance adjustment film for adjusting reflectance of light, including:
a plurality of films laminated together, wherein
the plurality of films includes:
   a low refractive index film, and
   a high refractive index film having a refractive index higher than that of the low refractive index film,
   at least one of the films adjacent to the high refractive index film has a refractive index lower than that of the high refractive index film, and
   hardness of the reflectance adjustment film is 6.0 GPa or more.

### (Supplementary Note 6)

The reflectance adjustment film according to any one of Supplementary Notes 1 to 4, wherein the refractive index of the low refractive index film with respect to a wavelength of 500 nm is in a range of 1.47 to 1.58.

### (Supplementary Note 7)

The reflectance adjustment film according to any one of Supplementary Notes 1 to 6, wherein the number of the plurality of films is 3 or more.

### (Supplementary Note 8)

The reflectance adjustment film according to any one of Supplementary Notes 1 to 7, wherein the high refractive index film is formed of at least one selected from the group consisting of tantalum pentoxide (Ta₂O₅), niobium pentoxide (Nb₂O₅), titanium oxide (TiO₂), zirconium oxide (ZrO₂), and cerium oxide (CeO₂).

### (Supplementary Note 9)

The reflectance adjustment film according to any one of Supplementary Notes 1 to 8, the reflectance adjustment film being an antireflection film for preventing reflection of light.

### (Supplementary Note 10)

A laminate including the reflectance adjustment film according to any one of Supplementary Notes 1 to 9, the reflectance adjustment film being formed on at least one surface of a substrate.

### (Supplementary Note 11)

The laminate according to Supplementary Note 10, wherein
a film farthest from the substrate in the plurality of films in the reflectance adjustment film is the low refractive index film.

### (Supplementary Note 12)

The laminate according to Supplementary Note 10 or 11, wherein
the substrate is at least one of glass or resin.

### (Supplementary Note 13)

A method for producing the reflectance adjustment film according to any one of Supplementary Notes 1 to 9, including:
forming the low refractive index film, and
forming the high refractive index film, wherein
the low refractive index film is formed by sputtering in the forming the low refractive index film, and
the high refractive index film is formed by sputtering in the forming the high refractive index film.

### (Supplementary Note 14)

A method for producing the laminate according to any one of Supplementary Notes 10 to 12, including producing the reflectance adjustment film on the substrate, by the method according to Supplementary Note 13.

This application claims priority from Japanese Patent Application No. 2023-075063 filed on April 28, 2023. The whole subject matter of the Japanese Patent Application is incorporated herein by reference.

### Reference Signs List

- 10, 10a: reflectance adjustment film
- 11, 11a: low refractive index film
- 12, 12a: high refractive index film
- 20: substrate
- 30: hard coat layer
- 100, 100a: laminate

## Claims

1. A reflectance adjustment film for adjusting reflectance of light, comprising:
a plurality of films laminated together, wherein
the plurality of films includes:
a low refractive index film, and
a high refractive index film having a refractive index higher than that of the low refractive index film,
the low refractive index film is formed of a mixture including silicon dioxide (SiO₂) and yttrium oxide (Y₂O₃), where some of the yttrium (Y) atoms in the yttrium oxide (Y₂O₃) are substituted with Group 4A element atoms, and
at least one of the films adjacent to the high refractive index film has a refractive index lower than that of the high refractive index film.

2. The reflectance adjustment film according to claim 1, wherein
some of the oxygen atoms in the yttrium oxide (Y₂O₃) are substituted with nitrogen (N) atoms.

3. The reflectance adjustment film according to claim 1 or 2, wherein
content of the yttrium oxide (Y₂O₃) in the low refractive index film is 1.0 mol% or more.

4. The reflectance adjustment film according to any one of claims 1 to 3, wherein
the Group 4A element atoms in the low refractive index film are zirconium (Zr) atoms.

5. The reflectance adjustment film according to any one of claims 1 to 4, wherein
the refractive index of the low refractive index film with respect to a wavelength of 500 nm is in a range of 1.47 to 1.58.

6. The reflectance adjustment film according to any one of claims 1 to 5, wherein
the high refractive index film is formed of tantalum pentoxide (Ta₂O₅).

7. The reflectance adjustment film according to any one of claims 1 to 6, the reflectance adjustment film being an antireflection film for preventing reflection of light.

8. A laminate comprising the reflectance adjustment film according to any one of claims 1 to 7, the reflectance adjustment film being formed on at least one surface of a substrate.

9. The laminate according to claim 8, wherein
a film farthest from the substrate in the plurality of films in the reflectance adjustment film is the low refractive index film.

10. A method for producing the reflectance adjustment film according to any one of claims 1 to 7, comprising:
forming the low refractive index film, and
forming the high refractive index film, wherein
the low refractive index film is formed by sputtering in the forming the low refractive index film, and
the high refractive index film is formed by sputtering in the forming the high refractive index film.
